# EUROPÄISCHE PATENTSCHRIFT

(11) **EP 1 586 914 B1**
(45) Veröffentlichungstag und Bekanntmachung des Hinweises auf die Patenterteilung: **03.03.2010**
(21) Anmeldenummer: 05007504.3
(22) Anmeldetag: 06.04.2005
(51) Int. Cl.: G01R 33/46

(54) **Digitale Filter für NMR- und MRI-Anwendungen**
Digital Filters for Use in NMR or MRI
Filtres digitaux pour application en RMN ou IRM

(30) Priorität: 10.04.2004 DE 102004017667
(43) Veröffentlichungstag der Anmeldung: 19.10.2005
(73) Patentinhaber: Bruker BioSpin AG, 8117 Fällanden (CH)
(72) Erfinder: Lendi, Pietro, 8730 Uznach (CH); Tschopp, Werner, Dr., 8127 Forch (CH)
(74) Vertreter: Kohler Schmid Möbus

(56) Entgegenhaltungen:
- EP-A- 0 412 747
- HOLLAND G N: "Whole Body Magnetic Resonance Spectrometers: All-Digital Transmit/Receive Systems" ENCYCLOPEDIA OF NUCLEAR MAGNETIC RESONANCE, Bd. 8, 1996, Seiten 5010-5014, XP002281107

## Beschreibung

### 1. Hintergrund

### Digitale Filter:

Digitale Filter werden schon seit längerer Zeit im Empfangssystem moderner NMR- und MRI-Spektrometer eingesetzt. Sie sind in der Regel als Tiefpassfilter ausgelegt, werden gleichzeitig mit dem Oversampling- und dem Dezimationsverfahren angewendet und da das Empfangssystem normalerweise einen Quadraturdetektor enthält, werden pro Empfangssystem jeweils zwei digitale Filter benötigt.

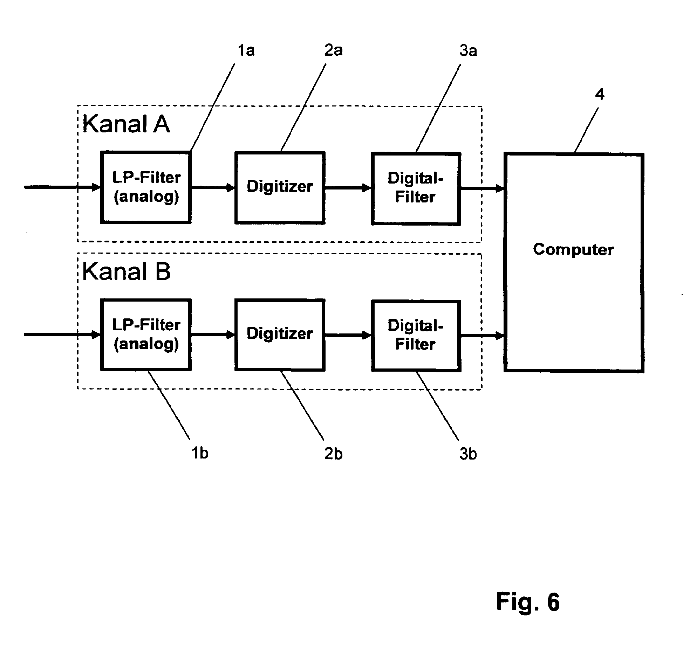

In Fig.6 sind die letzten Funktionsblöcke eines modernen NMR-Empfangssystems dargestellt. Man erkennt die beiden Quadraturkanäle A und B mit den beiden digitalen Filter 3a und 3b sowie den beiden Digitizer 2a und 2b, mit denen die beiden analogen NMR-Signale der Kanäle A und B digitalisiert werden.

Die Samplingrate der Digitizer wird üblicherweise so hoch wie möglich gewählt, um einerseits dem Entwurf der analogen Anti-Aliasing-Filter mehr Spielraum zu gewähren und anderseits vom Auflösungsgewinn des Oversamplingverfahrens zu profitieren. Da jedoch das digitale Filter eine Begrenzung der Frequenzbandbreite des gefilterten NMR-Signals und damit auch eine Reduktion der maximalen Frequenz, die im gefilterten NMR-Signal auftreten kann, vornimmt, fallen viel mehr Daten an, als dies das Nyquist-Theorem verlangt. Aus diesem Grund wird nach dem digitalen Filter auch noch eine Dezimierung der Datenrate vorgenommen (Dezimationsverfahren).

Vor den beiden Digitizer befinden sich analoge Tiefpass-Filter, sogenannte Anti-Aliasing Filter, deren Grenzfrequenz tiefer als die halbe Oversamplingrate sein muss, damit das Nyquist-Kriterium nicht verletzt wird. Die Ausgangssignale der beiden digitalen Filter werden in einen Computer geführt, wo sie einem Rechenvorgang RV unterworfen und mit Hilfe einer anschliessenden Fourier-Transformation zum gewünschten NMR-Spektrum oder MRI Bild transformiert werden.

Digitale Filter sind heute in der NMR und MRI kaum mehr wegzudenken, da sie folgende wichtige Vorteile besitzen:
1. Sie haben im Passband einen sehr flachen Amplitudengang, welcher praktisch zu keiner Verfälschung der Signalamplituden führt. Dies ist insbesondere bei der Integration der NMR-Signale wichtig.
2. Das Transitionsband, das den Übergang vom Pass- zum Stopband definiert, kann sehr schmal gewählt werden, so dass ein scharf definierter Bereich des NMR-Spektrums herausgeschnitten werden kann.
3. NMR-Signale innerhalb des Stopbandes lassen sich stark unterdrücken, auch wenn diese sehr nahe beim Transitionsband liegen, und können deshalb bei einer nachfolgenden Dezimation nicht mehr ins gewünschte Passband zurück gefaltet werden.

Unter den verschiedenen zur Anwendung kommenden digitalen Filter haben sich zwei wesentliche Grundtypen etabliert, nämlich das "Infinite Impulse Response" Filter (= IIR-Filter) und das "Finite Impulse Response" Filter (= FIR-Filter). In der NMR und MRI wird fast ausschliesslich das exakt linearphasige FIR-Filter benutzt, weil dieses erstens keine phasenbedingten Verzerrungen verursacht, und zweitens eine endliche Impuls-Antwortfunktion besitzt, wodurch das gefilterte NMR-Signal zeitlich begrenzt wird.

Der wesentlichste Nachteil bei der Anwendung von linearphasigen FIR Filter in der NMR und MRI liegt im zeitlichen Verlauf des NMR-Signals am Ausgang des Filters. Dieses zeigt den bei den linearphasigen und steilen digitalen Filter typischen Einfluss der grossen Gruppenlaufzeit T_{B}, nämlich dass das FID-Signal erst nach einem langen Einschwingvorgang der Länge T_{B} erscheint, was eine sehr grosse lineare Phasenkorrektur im NMR-Spektrum erfordert, und dass am Ende des FID-Signals ein langer Ausschwingvorgang ebenfalls der Länge T_{B} vorhanden ist.

Dazu kommen noch weitere Merkmale:
- Am Ausgang des Filters entstehen mehr Datenpunkte als am Eingang eingegeben wurden. Durch geeignete Massnahmen kann jedoch dieses Merkmal kompensiert werden.
- Bei einer allfälligen Anwendung von Fensterfunktionen (Window Functions) und/oder von "Backward Linear Prediction" Methoden (BLP) muss der Einfluss der Gruppenlaufzeit berücksichtigt werden.
- Bei der Kompensation eines möglicherweise vorhandenen DC-Anteils im gefilterten NMR-Signal muss ebenfalls der Einfluss der Gruppenlaufzeit berücksichtigt werden.

### NMR-Signal am Ausgang eines linearphasigen FIR-Filters:

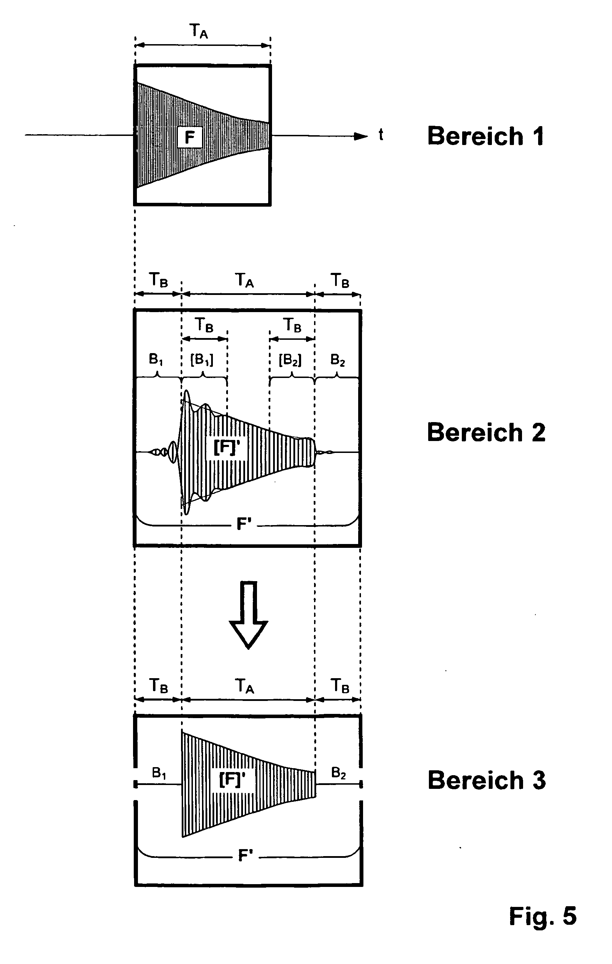

In Fig.5, Bereich 2, ist das NMR-Signal F' am Ausgang des FIR Filters dargestellt. Es setzt sich aus dem Einschwingbereich B₁ der Länge T_{B}, dem eigentlichen NMR-Signal [F]' der Länge T_{A}, sowie dem Ausschwingvorgang B₂ der Länge T_{B} zusammen. Die Ein- und Ausschwingvorgänge setzen sich aber nicht nur aus den Anteilen B₁ resp. B₂ zusammen, sondern besitzen zudem noch die Anteile [B₁] resp. [B₂], die beide innerhalb von [F]' liegen. Man beachte ferner, dass die Erfassungszeit T_{ERF} des NMR-Signals nach dem FIR Filter grösser ist als diese vor dem FIR Filter, nämlich (T_{B} + T_{A} + T_{B}) gegenüber T_{A}.

Um eine vereinfachte Darstellungsweise des gefilterten NMR-Signals inklusive der Ein- und Ausschwingvorgänge zu erhalten, soll in Zukunft an Stelle der genauen Darstellung mit eingezeichneten Ein- und Ausschwingvorgängen gemäss Bereich 2 von Fig.5, eine vereinfachte symbolische Darstellung gemäss Bereich 3 von Fig.5 verwendet werden.

Wie sich zeigen wird, ist es zweckmässig, die Gruppenlaufzeit T_{B} des digitalen Filters so zu wählen, dass eine exakte Trennung der drei Signalbereiche B₁, [F]' und B₂ möglich ist. Erreicht wird dies, indem die Gruppenlaufzeit T_{B} gleich einem ganzzahligen Vielfachen der Periodenzeit der dezimierten Samplingrate gewählt wird. Diese Bedingung ist zwar nicht zwingend notwendig, sie führt jedoch zu einer wesentlich vereinfachten Signalverarbeitung.

### Der Rechenvorgang RV

Sowohl in der NMR wie auch in der MRI ist nicht das NMR-Signal (= Zeitsignal) das Endziel, sondern das NMR-Spektrum resp. das MRI-Bild. Beides bedingt, dass eine Fourier-Transformation des NMR-Signals ausgeführt wird, d.h. eine Transformation vom Zeit- in den Frequenzbereich vorgenommen wird. Damit bei dieser Transformation keine Verfälschungen oder zusätzlichen Verzerrungen im NMR-Spektrum entstehen, sollten die NMR-Spektren des gefilterten und des nicht gefilterten NMR-Signals einander bis auf die Filterfunktion möglichst genau entsprechen. Erreicht wird dies, indem zuerst ein spezieller Rechenvorgang RV am gefilterten NMR-Signal ausgeführt wird, bevor dieses dann der Fourier-Transformation zugeführt wird.

Der Rechenvorgang RV hat die Aufgabe, die Erfassungszeit (T_{B} + T_{A} + T_{B}) des gefilterten NMR-Signals F' an die Erfassungszeit T_{A} des NMR-Signals F am Eingang des Filters anzugleichen, d.h. auf den Wert T_{A} zu reduzieren, und zwar möglichst ohne dabei zusätzliche Verzerrungen im Frequenzspektrum zu erzeugen. Auf diese Weise kann die Bedingung, dass die NMR-Spektren des gefilterten und des nicht gefilterten NMR-Signals einander bis auf die Filterfunktion möglichst genau entsprechen, erfüllt werden.

Die Richtigkeit des obigen Vorgehens ist leicht einzusehen, wenn man beachtet, dass die Fourier-Transformation implizit und automatisch eine Periodisierung des zu transformierenden NMR-Signals vornimmt, und deshalb die Erfassungszeiten der beiden NMR-Signale am Eingang und Ausgang des Filters gleich gross sein müssen, damit gleiche Periodenzeiten entstehen.

Diese Patentschrift bezieht sich ausschliesslich auf diesen Rechenvorgang RV, der nachfolgend näher beschrieben wird, zuerst für den Stand der Technik und anschliessend für das erfindungsgemässe Verfahren.

### 2. Stand der Technik

### Hochauflösende NMR-Spektroskopie (T_{B} <<T_{A} ):

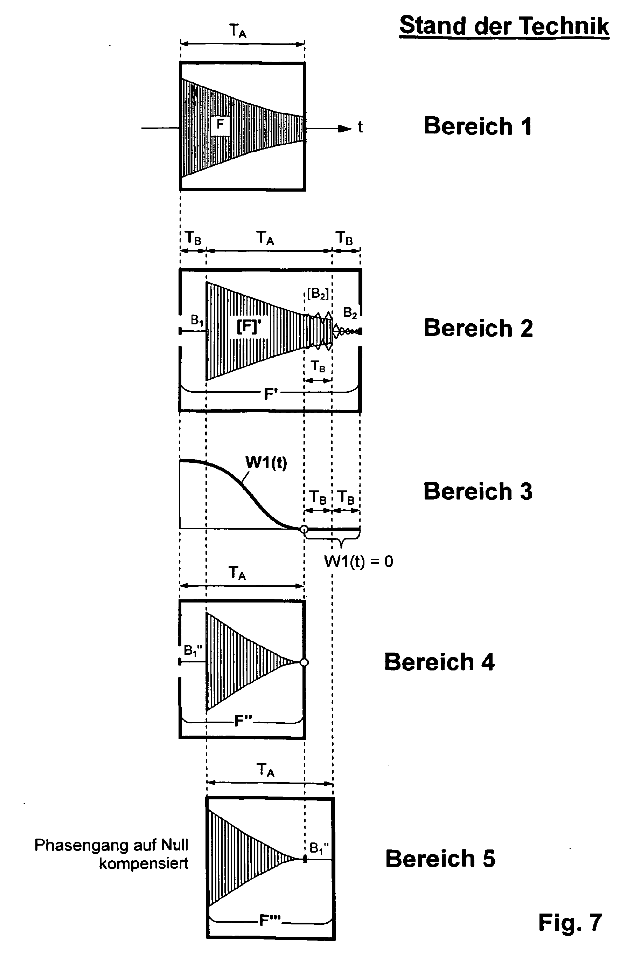

Der Rechenvorgang RV, der heute bei der hochauflösenden NMR-Spektroskopie normalerweise angewendet wird, besteht darin, dass in einem ersten Schritt das gefilterte NMR-Signal mit einer speziell für diesen Rechenvorgang vorgesehenen Fensterfunktion W1(t) (siehe Fig.7, Bereich 3) multipliziert wird, so dass ein NMR-Signal der Länge T_{A} übrig bleibt (siehe Fig.7, Bereich 4). Erreicht wird dies, indem W1(t) so gewählt wird, dass ein Bereich von 2·T_{B} am Ende des NMR-Signals mit Null multipliziert wird und deshalb weggeschnitten werden darf. Auf diese Weise bleibt wunschgemäss ein NMR-Signal der Länge T_{A} übrig.

Unter den weggeschnittenen Signalanteilen befindet sich auch der Ausschwingvorgang B₂, was eigentlich im NMR-Spektrum zu Verzerrungen führen müsste. Damit das aber nicht geschieht, wurde nicht nur B₂, sondern auch der Teil [B₂] (siehe Fig.7, Bereich 2) innerhalb des NMR-Signals [F]', der ebenfalls Ausschwingvorgänge enthält, weggeschnitten. Da nun nicht nur ein Teil sondern sämtliche Ausschwingvorgänge im Endbereich des NMR-Signals F' eliminiert wurden, können diese auch keinen Einfluss auf das NMR-Spektrum nehmen. Da mit diesem Verfahren Signalanteile weggeschnitten werden, bedeutet dies einen gewissen Verlust an Information, der aber im Falle der hochauflösenden NMR-Spektroskopie sehr gering ist, denn dort gilt normalerweise T_{B} << T_{A}.

Wenn durch die weggeschnittenen Anteile ein abrupter Signalabfall am Ende des resultierenden NMR-Signals entstanden ist, dann führt dieser, falls keine Gegenmassnahmen getroffen werden, zu Basislinien-Verzerrungen im NMR-Spektrum. Um dies zu verhindern, muss das gefilterte NMR-Signal anschliessend mit einer geeigneten Fensterfunktion W1(t) multipliziert werden, wodurch der abrupte Abfall geglättet wird.

Solche Anwendungen von Fensterfunktionen sind in der NMR übrigens allgemein üblich, insbesondere dann, wenn nicht genügend Zeit zur Verfügung steht, um das NMR-Signal vollständig ausklingen zu lassen (Steady State Experimente, Mehrdimensionale Experimente), aber trotzdem genügend Signal zu Rauschen sowie Auflösung vorhanden sind.

In einem letzten Schritt wird der vom digitalen Filter herrührende steile Phasengang mit Hilfe einer grossen linearen Phasenkorrektur kompensiert. Dies kann erstens durch eine entsprechende Phasenkorrektur im Frequenzbereich, oder zweitens durch zyklische Rotation des NMR-Signals im Zeitbereich erreicht werden. Im zweiten Fall verschiebt sich der Einschwingvorgang B₁" ans Ende von F" (siehe Fig.7, Bereich 5).

Das digitale NMR-Signal F' am Ausgang des digitalen Filters enthält normalerweise unerwünschte Störkomponenten, die von der Qualität der verwendeten Empfangselektronik herrühren. So kann z.B. eine störende DC-Komponente vorhanden sein, die unbedingt noch vor der Anwendung der Fensterfunktion W1(t) und der Fourier-Transformation eliminiert werden muss, da sonst zusätzliche Störkomponenten im NMR-Spektrum entstehen können.

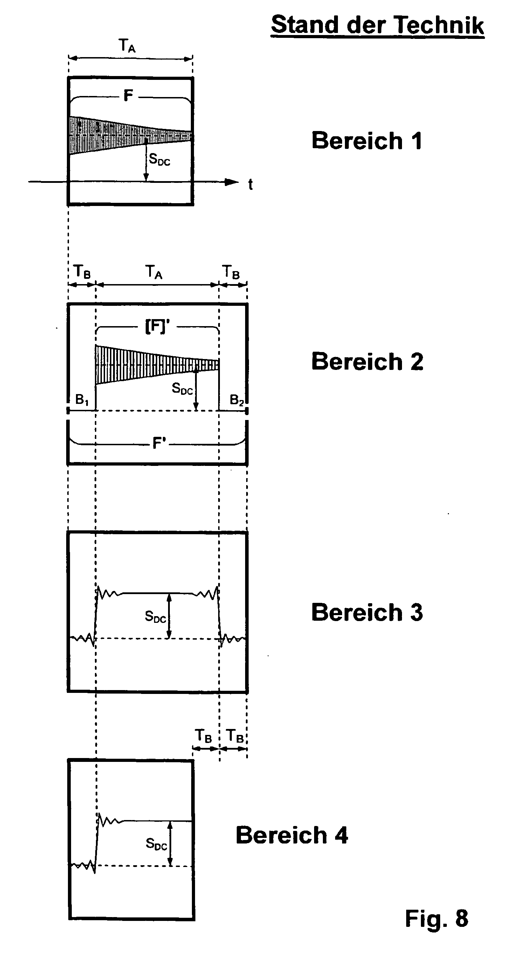

Die Abbildungen in Fig.8 zeigen ein NMR-Signal mit einem übertrieben hohen DC-Anteil S_{DC}. Bereich 1 zeigt den DC-Anteil vor der Filterung und Bereich 2 nach der Filterung, beide Male jedoch ohne die Ein- und Ausschwingvorgänge. Bereich 3 zeigt nur den DC-Anteil für sich, dieses Mal jedoch mit den Ein- und Ausschwingvorgängen. Nach Abschneiden einer Länge 2·T_{B} am Ende der Funktion F' (siehe Fig.7), entsteht ein DC-Anteil, der aus einer um T_{B} verzögerten Sprungfunktion der Höhe S_{DC} besteht, mit Ein- und Ausschwingvorgängen am Sprungpunkt (siehe Fig.8, Bereich 4).

Der Wert S_{DC} kann leicht aus der Funktion F' bestimmt werden, indem der Endbereich der Funktion F' gewählt und mit Hilfe einer Mittelwert Bildung der Wert S_{DC} daraus ermittelt wird. Da nun S_{DC} bekannt ist, lässt sich damit die reine Sprungfunktion ohne Ein- und Ausschwingvorgänge eindeutig definieren. Es genügt jedoch nicht, diese Funktion für die Kompensation des DC-Anteils von F' zu benutzen, denn die Ein- und Ausschwingvorgänge von F' würden immer noch übrig bleiben und Störungen im NMR-Spektrum verursachen.

Die Ein- und Ausschwingvorgänge für eine reine Sprungfunktion der Höhe S_{DC} lassen sich jedoch rein rechnerisch ermitteln, da alle Parameter des digitalen Filters bekannt sind. Addiert man die berechneten Ein- und Ausschwingvorgänge zur reinen Sprungfunktion, so resultiert daraus die gewünschte Funktion, mit welcher der DC-Anteil von F' vollständig kompensiert werden kann.

### Bildgebende MRI (T_{B} ≈ T_{A} sowie T_{B} > T_{A}):

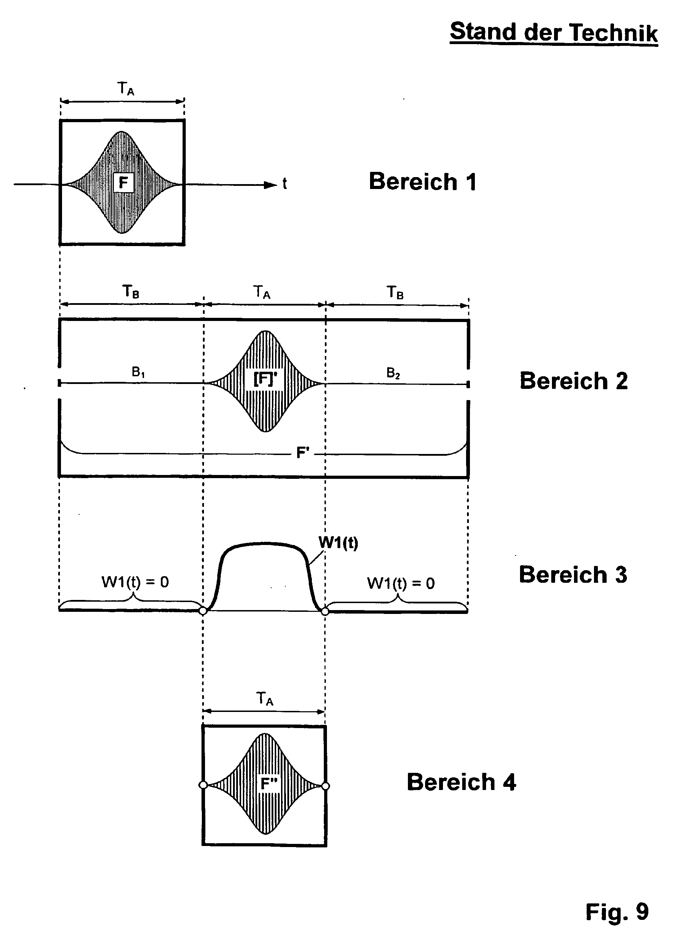

Bei der MRI hingegen können die Verhältnisse völlig anders liegen. Dort kann je nach gewählter Charakteristik des digitalen Filters die Gruppenlaufzeit T_{B} ungefähr gleich oder grösser als T_{A} werden, so dass der für die hochauflösende NMR-Spektroskopie beschriebene Rechenvorgang RV hier völlig versagen würde. Da aber in der MRI normalerweise mit Echo-Signalen (siehe Fig.9, Bereich 1) gearbeitet wird, und diese mit einem kleinen Wert anklingen , einen Maximalwert erreichen, anschliessend wieder abfallen und letztendlich wieder einen kleinen Wert erreichen, ist trotzdem eine einfache Lösung möglich.

Im Bereich 2 von Fig.9 ist das Echo-Signal am Ausgang des digitalen Filters dargestellt, und man erkennt leicht, dass T_{B} > T_{A} ist. Die Ein- und Ausschwingvorgänge B₁ und B₂ sind normalerweise vernachlässigbar klein und können deshalb mit Hilfe der Fensterfunktion W1(t) (siehe Fig.9, Bereich 3) gleich Null gesetzt und weggeschnitten werden. Auch in diesem Fall erhält man wunschgemäss ein Echo-Signal der Länge T_{A} (siehe Fig.9, Bereich 4).

Das Wegschneiden der sehr schwachen Ein- und Ausschwingvorgänge bedeutet aber trotzdem ein kleiner Verlust an Information, der in gewissen Fällen trotzdem zu einer nicht übersehbaren Verschlechterung der Qualität der MRI Bilder führen kann.

Das Echo-Signal kann ebenfalls einen DC-Anteil besitzen, der sich aber wie bei der hochauflösenden NMR-Spektroskopie kompensieren lässt.

Wenn in der MRI andere Messmethoden verwendet werden, die z.B. Halb-Echo-Signale oder FID-Signale benutzen, dann muss dafür gesorgt werden, dass T_{B} << T_{A} wird, und das ist nur möglich, wenn die Gruppenlaufzeit des digitalen Filters entsprechend klein gewählt wird. Ist dies der Fall, dann kann die weiter oben beschriebene Methode für die hochauflösende NMR-Spektroskopie angewendet werden.

### Der Rechenvorgang RV in zusammengefasster Form:

Der Rechenvorgang RV setzt sich aus den folgenden drei Schritten zusammen, die chronologisch in der angegebenen Reihenfolge auszuführen sind:
1. Kompensation des DC-Anteils im gefilterten NMR-Signal F'
2. Multiplikation mit einer geeigneten Fensterfunktion W1(t)
3. Kompensation des Phasenganges auf Null indem der Einschwingvorgang B₁ ans Ende des NMR-Signals gesetzt wird (bei der MRI hat dieser Schritt keine Bedeutung, weil der Einschwingvorgang weggeschnitten wurde).

### Nachteile des Rechenvorganges RV:

1. Die Gruppenlaufzeit des digitalen Filters ist nicht frei wählbar, sondern muss an das vorhandene NMR- resp. Echo-Signal angepasst werden. Dies gilt insbesondere für die MRI.
2. Bei der Kompensation des DC-Anteils müssen Ein- und Ausschwingvorgänge mit Hilfe der Filterparameter berechnet werden. Das hat zur Folge, dass die Hersteller von NMR-Spektrometer die Filterparameter ihrer FIR-Filter an die Fremdanbieter von Anwendungs-Software weitergeben müssen, wodurch geheimes Know-How zum Konkurrenten gelangen kann.
3. Der Rechenvorgang RV ist nur mit Hilfe von Fensterfunktionen möglich.
4. Bei der hochauflösenden NMR-Spektroskopie muss ein Teil des FID-Signals weggeschnitten werden, wodurch ein Teil der Information verloren geht.
5. Bei der MRI ist man normalerweise gezwungen, mit Echo-Signalen zu arbeiten. Obwohl man das in den meisten Fällen ohnehin tun würde, bedeutet dies trotzdem eine Einschränkung der Möglichkeiten.
6. Bei der MRI müssen die Ein- und Ausschwingvorgänge B₁ und B₂ weggeschnitten werden. Diese sind im Allgemeinen sehr klein im Vergleich zum Echo-Signal, aber trotzdem geht dabei Information verloren, die eine Verschlechterung der Schärfe der Schnittbilder zur Folge haben kann.

### 3. Das erfindungsgemässe Verfahren

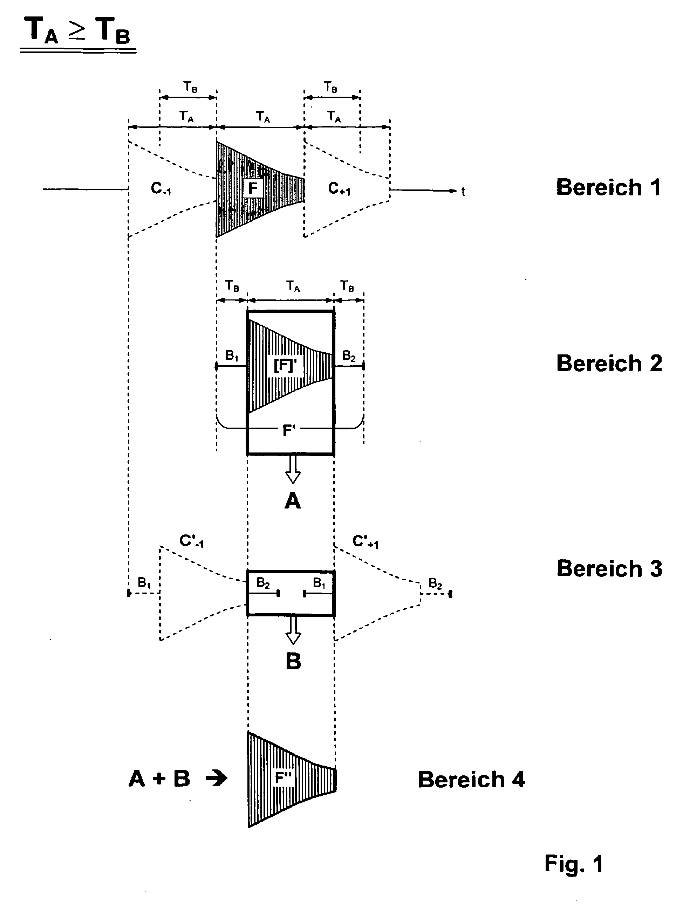

Ziel des erfindungsgemässen Verfahrens ist es, einen neuen Rechenvorgang RV zu definieren, der den Einfluss der Gruppenlaufzeit von digitalen, linearphasigen Filtern mathematisch exakt kompensiert. Dabei soll aus dem NMR-Signal F' (siehe z.B. Fig.1) der Länge T_{A} + 2·T_{B} am Ausgang des digitalen Filters ein NMR-Signal F" der Länge T_{A} entstehen, das die Nachteile und Einschränkungen des heutigen Stand der Technik nicht mehr besitzt. Insbesondere dürfen keine Teile des gefilterten NMR-Signals weg geschnitten oder Ein- und Ausschwingvorgänge unberücksichtigt bleiben.

Die zentrale Idee bei der Ableitung des neuen Rechenvorganges RV besteht darin, dass die implizit vorhandene Eigenschaft der Fourier-Transformation, nämlich dass sie automatisch eine Periodisierung des zu transformierenden NMR-Signals vornimmt, konsequent und mathematisch genau berücksichtigt wird.

Dies geschieht dadurch, dass die Funktion F der Länge T_{A} am Eingang des digitalen Filters nicht für sich alleine betrachtet wird, sondern als eine unendlich lange periodische Funktion mit der Periodenzeit T_{A}. Die einzelnen Signalanteile innerhalb der Periodenabschnitte T_{A} sind dann alle gleich der Funktion F.

In Gedanken wird nun die unendliche Kette aus Signalanteilen F, die wir als F1 bezeichnen wollen, durch das digitale Filter geleitet, und da es sich bei einem digitalen Filter um ein lineares, zeitinvariantes System (LTI-System) handelt, darf das Superpositionsprinzip angewendet werden, d.h. die einzelnen Signalanteile F von F1 dürfen getrennt und einzeln durch das digitale Filter geleitet und dort als einzelne gefilterte Signalanteile F' wieder zueinander addiert werden. Dadurch entsteht ein neues periodisches Signal, das wir als F2 bezeichnen wollen, und das ebenfalls eine Periodenzeit T_{A} besitzt. Die einzelnen Signalanteile von F2 sollen mit F" bezeichnet werden. Man beachte, dass die Fourier-Transformation von F" bis auf den Einfluss der Filterfunktion zwangsläufig identisch mit der Fourier-Transformation von F sein muss. Das heisst aber, dass das NMR-Spektrum der beiden Funktionen F und F" bis auf die Filterfunktion ebenfalls identisch sein müssen, und das entspricht genau dem gewünschten Ziel.

Obiger Vorgang kann auch folgendermassen beschrieben werden. Das gefilterte NMR-Signal F' wird gedanklich in unendlicher Anzahl kopiert und die einzelnen Kopien in Abständen von T_{A} vor und nach dem Signal F' positioniert. Dabei entstehen zwangsläufig Überlappungen, weil das Signal F' sowie dessen Kopien infolge ihrer Ein- und Ausschwingvorgänge länger als T_{A} sind. Addiert man nun diese Kopien zum Signal F', so entsteht das oben beschriebene periodische Signal F2, das aus lauter Signalanteilen F" zusammengesetzt ist.

Gedanklich darf man nun die Periodisierung wieder rückgängig machen, da die anschliessende Fourier-Transformation diese wieder automatisch einführen wird. Es genügt deshalb, die einzelnen Signale F und F", die beide die Länge T_{A} besitzen, für sich alleine zu betrachten, und da das Signal F" keine explizite Gruppenlaufzeit T_{B} besitzt, hat sie auch keinen steilen Phasengang sondern wunschgemäss einen Null Phasengang (Zerophase).

Selbstverständlich darf das Signal F" zusätzlich noch mit einer Fensterfunktion W2(t) multipliziert werden, was dann sinnvoll sein kann, wenn das ursprüngliche NMR-Signal F am Ende des NMR-Signals wie bereits beschrieben, einen abrupten Abfall besitzt, der zwangsläufig auch auf F" übertragen wird. Solche Abfälle erzeugen im Allgemeinen Verzerrungen der NMR-Linien, und um diese möglichst klein zu halten, wird F" zuerst mit einer Fensterfunktion multipliziert, die im Endbereich einen monotonen Abfall auf Null besitzt, und erst dann der Fourier-Transformation zugeführt.

Bei den obigen Überlegungen zum Rechenvorgang RV wird mit unendlich langen periodischen Funktionen gerechnet. Da jedoch das gefilterte NMR-Signal F' infolge der endlichen Impuls-Antwortfunktion des FIR-Filters zeitlich begrenzt ist, genügt es, wenn nur eine endliche Anzahl (1 + 2·N) von Kopien der Funktionen F' berücksichtigt werden, um daraus die Funktion F" zu berechnen.

In Fig.1 ist der Fall T_{A} ≥ T_{B} dargestellt, und man erkennt, dass drei aufeinander folgende Signale F', nämlich C'₋₁, F' und C'₊₁, vollständig genügen, um F" zu definieren (Siehe Bereich 2 und 3). C'₋₁ und C'₊₁ sind Kopien von F', und sie sind jeweils um T_{A} in positiver und negativer Richtung gegenüber F' verschoben. Weitere Kopien von F' sind überflüssig, da sie so weit von F' liegen, sodass ihre Ein- oder Ausschwingvorgänge das Signal F' gar nicht mehr überlappen können. In diesem Fall gilt also N = 1.

Fig.1 zeigt, wie zuerst nur das NMR-Signal [F]' gewählt und als Wert A gespeichert wird (Bereich 2). Anschliessend wird der Ausschwingvorgang B₂ von C'₋₁ und der Einschwingvorgang B₁ von C'₊₁ gewählt und als Wert B gespeichert (Bereich 3). Am Schluss wird A und B addiert, was zum gewünschten Signal F" der Länge T_{A} führt (Bereich 4).

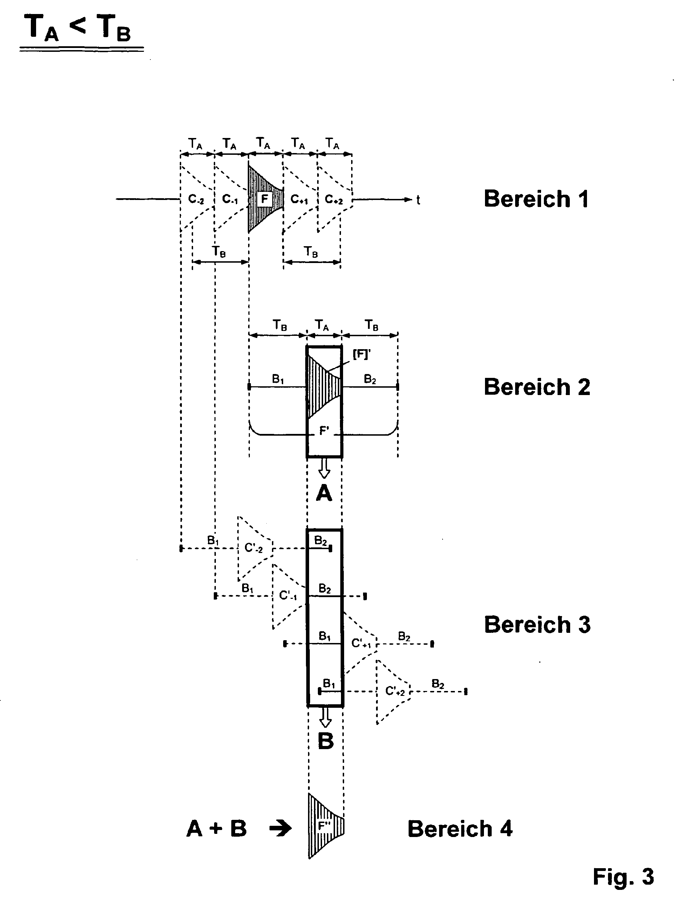

Im Falle von T_{A} < T_{B} müssen mehr als drei aufeinander folgende Signale F' berücksichtigt werden. Fig.3 zeigt ein entsprechendes Beispiel, bei dem T_{B} = 1.33·T_{A} gilt und fünf aufeinander folgende Signale F' notwendig sind, um F" zu definieren, nämlich C'₋₂, C'₋₁, F', C'₊₁ und C'₊₂. Der Rechenvorgang RV verläuft analog zu Fig.1, mit dem Unterschied aber, dass bei der Berechnung des Wertes B nur Teile der Ein- und Ausschwingvorgänge addiert werden müssen. In diesem Fall gilt also N = 2.

Im allgemeinen Fall gilt, dass die minimale Anzahl aufeinander folgender Signale F', die berücksichtigt werden müssen, gleich 1 + 2·N sein muss, wobei N vorerst durch den Quotientenwert (T_{B} / T_{A}) bestimmt wird, der aber anschliessend auf die nächst höhere ganze Zahl aufgerundet werden muss.

### DC-Anteil, Fensterfunktion und "Zero Filling":

Der im berechneten NMR-Signal F" normalerweise vorhandene DC-Anteil muss zuerst kompensiert werden, bevor weitere rechnerische Manipulationen an F" ausgeführt werden. Der DC-Anteil besteht jedoch in diesem Fall nur aus einem konstanten Wert S_{DC} ohne Ein- oder Ausschwingvorgänge, und es genügt deshalb, diesen mit Hilfe einer Mittelwertbildung des Endbereiches von F" zu bestimmen und vom Signal F" abzuziehen. Im Gegensatz zum Stand der Technik erfordert diese Kompensation somit keine Kenntnisse der Filterparameter, und deshalb ist der Hersteller von NMR-Spektrometer auch nicht gezwungen, diese Filterparameter an Fremdanbieter von Anwendungs-Software weiterzugeben.

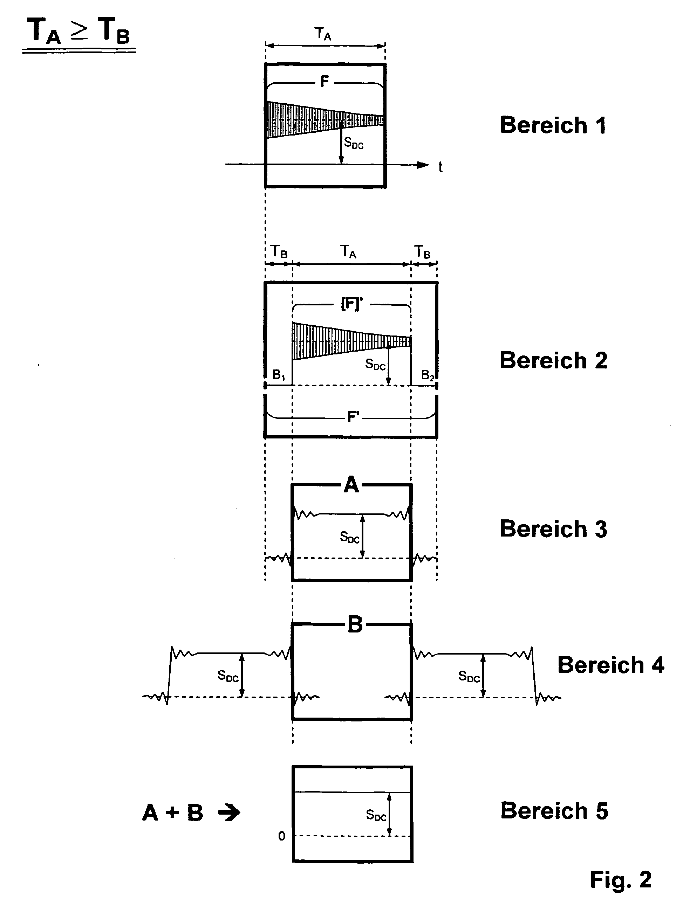

In Fig.2 wird gezeigt, wie der DC-Anteil des Signals F" entsteht. Fig.2, Bereich 2 zeigt das gefilterte NMR-Signal mit dem DC-Anteil S_{DC}. Im Bereich 3 ist der ganze Verlauf des DC-Anteils des Signals F' getrennt dargestellt. Er besitzt dort noch Ein- und Ausschwingvorgänge. Nachdem jedoch die beiden Kopien des DC-Anteils links und rechts vom ursprünglichen DC-Anteil positioniert wurden (siehe Bereich 4) und alle drei DC-Anteile addiert wurden, entsteht ein DC-Anteil ohne Ein- und Ausschwingvorgänge (siehe Bereich 5). Die Ein- und Ausschwingvorgänge haben sich gegenseitig kompensiert! Damit ist gezeigt, dass der DC-Anteil des Signals F" nur aus einem konstanten Wert S_{DC} besteht.

Nachdem das Signal F" von seinem DC-Anteil entledigt wurde, kann F" mit einer Fensterfunktion W₂(t) multipliziert werden, sofern der Anwender das wünscht.

Es ist auch erlaubt, am Ende des Signals F" einen aus lauter Nullwerten bestehender Abschnitt hinzuzufügen (in der Fachsprache nennt man dies "Zero Filling"), um eine künstliche Verbesserung der Auflösung des NMR-Spektrums zu erreichen.

### Vorteile des Rechenvorganges RV:

1. Bei der Wahl der Gruppenlaufzeit des digitalen Filters besteht keine Einschränkung. Dies gilt insbesondere bei der MRI.
2. Der Rechenvorgang RV benötigt grundsätzlich keine speziellen Fensterfunktionen W1(t). Die Ein- und Ausschwingvorgänge, die durch das FIR-Filter verursacht werden, sind im resultierenden Signal F" vollständig enthalten.
3. Es müssen keine Teile des NMR-Signals weg geschnitten werden. Deshalb geht auch keine allfällige Information verloren..
4. Das nach dem Rechenvorgang RV resultierende Signal F" hat dieselbe Länge T_{A} wie des Signal F am Eingang des FIR-Filters und besitzt zudem automatisch einen Null Phasengang (Zero Phase). Es sieht also so aus wie wenn man mit einem linearphasigen Null-Phasen-Filter gearbeitet hätte.
5. Der DC-Anteil im Signal F" besteht nur aus einem konstanten Wert S_{DC} ohne Ein- und Ausschwingvorgänge. Deshalb ist die Kompensation des DC-Anteils denkbar einfach, indem nur ein konstanter DC-Wert vom Signal F" abgezogen werden muss. Es müssen deshalb auch keine Informationen über die Filterparameter an die Fremdanbieter von Anwendungs-Software weitergegeben werden.
6. In der MRI ist man nicht mehr auf die primäre Verwendung von Echo-Signalen angewiesen, d.h. es können auch normale FID-Signale verarbeitet werden, ohne dass dadurch Verzerrungen im MRI-Bild entstehen.

### Der Rechenvorgang RV in zusammengefasster Form:

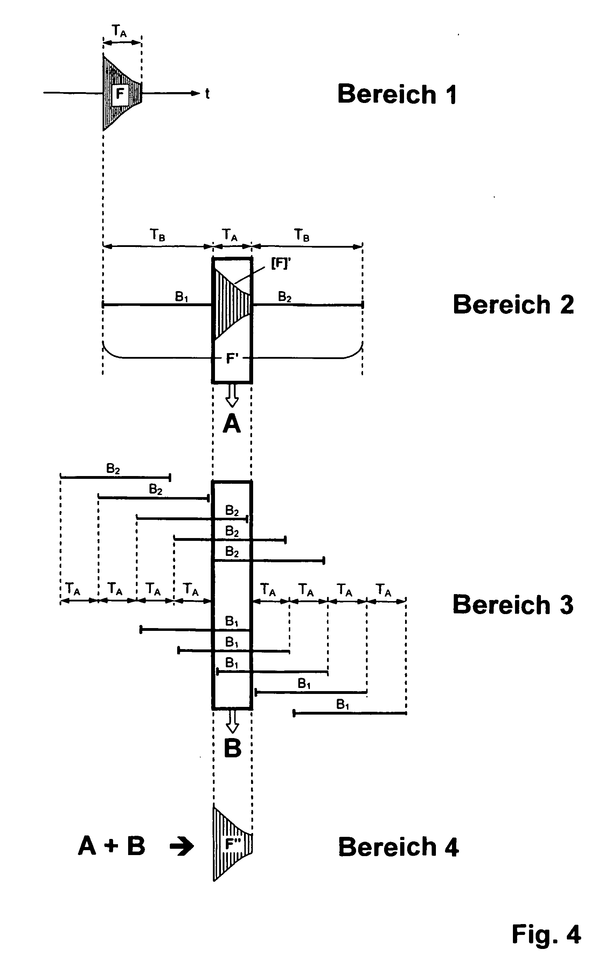

Aus den vorangegangenen Erläuterungen lässt sich für den Rechenvorgang RV ein Rezept ableiten, das für alle beschriebenen Fälle des erfinderischen Verfahrens Gültigkeit hat. Es besteht aus den folgenden Schritten:
1. Aus dem digital gefilterten NMR-Signal F' den Signalanteil [F]' der Länge T_{A} wählen (= A in Fig.4, Bereich 2).
2. Mindestens N Kopien des Einschwingvorgangs B₁ in positiven zeitlichen Abständen T_{A} zueinander erzeugen und auf dem Signalanteil [F]' so positionieren, dass das Ende des ersten Einschwingvorgangs auf das Ende von [F]' zu liegen kommt (siehe Fig.4, Bereich 3).
3. Mindestens N Kopien des Ausschwingvorgangs B₂ in negativen zeitlichen Abständen T_{A} zueinander erzeugen und auf dem Signalanteil [F]' so positionieren, dass der Anfang des ersten Ausschwingvorgangs auf den Anfang von [F]' zu liegen kommt (siehe Fig.4, Bereich 3).
4. Alle so definierten N Kopien des Einschwingvorganges und N Kopien des Ausschwingvorgangs (= B in Fig.4, Bereich 3) zum Signalanteil [F]' addieren und davon nur den Bereich T_{A} wählen, der den Signalanteil [F]' enthält. Dadurch entsteht das gewünschte NMR-Signal F" (siehe Fig.4, Bereich 4), das automatisch einen Nullphasengang besitzt.
5. Den DC-Anteil S_{DC} im NMR-Signal F" kompensieren. Dies geschieht durch eine simple Subtraktion eines konstanten Wertes S_{DC} (siehe Fig.2, Bereich 5) vom NMR-Signal F". Ein- und Ausschwingvorgänge des DC-Anteils existieren nicht und müssen deshalb nicht berücksichtigt werden!
6. Eine evtl. gewünschte Multiplikation mit einer Fensterfunktion W2(t) oder "Zero Filling" kann an dieser Stelle ausgeführt werden.
7. Das NMR-Signal der Fourier-Transformation zuführen.

Um die Zahl N zu erhalten, wird zuerst mit Hilfe der Formel N = T_{B} / T_{A} ein Zwischenwert berechnet, der anschliessend auf die nächst höhere ganze Zahl aufgerundet wird.

Die ersten vier Schritte des obigen Rechenvorganges RV lassen sich auch wie folgt beschreiben:

Der Rechenvorgang RV besteht darin, dass zuerst nur das Signal [F]' gewählt wird, dass anschliessend mindestens N Kopien des Einschwingvorganges B₁ in positiven zeitlichen Abständen T_{A} zueinander erzeugt und auf [F]' positioniert werden, so dass das Ende des ersten Einschwingvorganges auf das Ende von [F]' zu liegen kommt, dass zudem mindestens N Kopien des Ausschwingvorgangs B₂ in negativen zeitlichen Abständen T_{A} zueinander erzeugt und auf [F]' positioniert werden, so dass der Anfang des ersten Ausschwingvorgangs auf den Anfang von [F]' zu liegen kommt, und dass am Ende alle so definierten N Kopien des Einschwingvorgangs und N Kopien des Ausschwingvorgangs zum Signal [F]' addiert werden, und davon nur der Bereich T_{A}, der das Signal [F]' enthält, als resultierendes Signal F" des Rechenvorganges RV gewählt wird, wobei die Zahl N mit Hilfe der Formel N = T_{B} / T_{A} zu berechnen und auf die nächst höhere ganze Zahl aufzurunden ist.

### 4. Erklärungen zu den Figuren

- Fig.1: Erfindungsgemässer Rechenvorgang RV, dargestellt für den Fall, dass die Gruppenlaufzeit T_{B} kleiner oder gleich der Aquisitionszeit T_{A} ist. Zu diesem Fall gehört z.B. die hochauflösende NMR-Spektroskopie. Das resultierende Signal F" enthält die beiden Ein- und Ausschwingvorgänge B₁ resp. B₂.
- Fig.2: Bestimmung des DC-Anteils de Signals F" gemäss dem erfindungsgemässen Verfahren. Der resultierende DC-Anteil besteht nur aus einem konstanten Wert S_{DC}. ohne irgendwelche Ein- oder Ausschwingvorgänge.
- Fig.3: Erfindungsgemässer Rechenvorgang RV, dargestellt für den Fall, dass die Gruppenlaufzeit T_{B} grösser als die Aquisitionszeit T_{A} ist. Zu diesem Fall gehört z.B. die MRI. Das resultierende Signal F" enthält eine Mehrzahl von überlagerten Ein- und Ausschwingvorgängen B₁ resp. B₂.
- Fig.4: Erfindungsgemässer Rechenvorgang RV für den allgemeinen Fall. Das resultierende Signal F" enthält eine Mehrzahl von überlagerten Ein- und Ausschwingvorgängen B₁ resp. B₂.
- Fig.5: Detaillierte Darstellung des gefilterten NMR-Signals F' (siehe Bereich 2) sowie eine vereinfachte, symbolische Darstellung des gleichen NMR-Signals F' (siehe Bereich 3).
- Fig.6: Aufbau des NF-Teils eines NMR- oder MRI-Empfangssystems. Dargestellt ist ein System, das typischerweise mit einer Quadratur Detektion arbeitet und deshalb zwei Kanäle A und B enthält.
- Fig.7: Rechenvorgang RV für die hochauflösende NMR-Spektroskopie gemäss dem Stand der Technik. Die gewünschte Länge T_{A} des resultierenden NMR-Signals konnte nur durch Wegschneiden von Signalanteilen und mit Hilfe einer Fensterfunktion W₁(t) erreicht werden.
- Fig.8: DC-Anteil der Funktion F" gemäss dem Stand der Technik. Dieser besteht aus einer Einheitssprungfunktion skaliert mit dem Wert S_{DC} mit dem Einschwingvorgang am Sprungpunkt. Die Kompensation dieses DC-Anteils samt Einschwingvorgang benötigt Kenntnisse über die Filterparameter.
- Fig.9: Rechenvorgang RV für die bildgebende MRI gemäss dem Stand der Technik. Die gewünschte Länge T_{A} des resultierenden Echo-Signals wird durch Wegschneiden der Signalanteile B₁ und B₂ erreicht. Letztere sind im Allgemeinen zwar verschwindend klein, in gewissen Fällen jedoch können sie trotzdem zu einer nicht übersehbaren Verschlechterung der Qualität der MRI Bilderführen.

### 5. Legende

- MRI: "Magnetic Resonance Imaging".
Bildgebendes NMR-Verfahren, bei dem geschaltete magnetische Gradientenfelder benutzt werden.
- Passband: Frequenzbereich, der vom digitalen Filter vollständig übertragen wird
- Transitionsband: Bereich innerhalb des Frequenzganges des digitalen Filters, der den Übergang vom Pass- zum Stopband darstellt. Hier werden die Frequenzanteile weder vollständig unterdrückt, noch vollständig übertragen.
- Stopband: Frequenzbereich, der vom digitalen Filter unterdrückt wird
- Anti-Aliasing-Filter: Analoges Tiefpassfilter, das noch vor dem Digitizer liegt und für die Erfüllung des Nyquist-Kriteriums verantwortlich ist.
- Dezimation: Reduktion der Samplingrate, die nach einer Begrenzung des Frequenzumfanges des NMR-Signals ausgeführt werden darf.
- Rechenvorgang: RV Dient der rechnerischen Transformation des gefilterten NMR-Signals, so dass dieses die Länge T_{A} erhält
- Kanal A: Erster Kanal der Quadratur-Detektion
- Kanal B: Zweiter Kanal der Quadratur-Detektion
- FID: "Free Induction Decay". Typisches, in der Regel exponentiell abklingendes NMR-Signal, das z.B. nach einem 90° Anregungspuls entstehen kann.
- Echo: Typisches, in der Regel exponentiell ansteigendes und anschliessend exponentiell abklingendes NMR-Signal, das z.B. nach einem 90° gefolgt von einem 180° Anregungspuls entstehen kann.
- DC-Anteil: Unerwünschter Gleichstromanteil im NMR-Signal; in der Regel ein Restsignal der Elektronik, das sich dem FID- oder Echo-Signal überlagert (DC = Direct Current).
- S_{DC}: Betrag des DC-Anteils
- W1(t): Fensterfunktion, mit der das gefilterte NMR-Signal nach dem bisherigen Rechenverfahren RV modifiziert werden musste.
- W2(t): Fensterfunktion, mit der das NMR-Signal noch vor der Fourier-Transformation multipliziert wird, um die Qualität des NMR-Spektrums zu verbessern. (z.B. Reduktion des Truncation-Effektes)
- Truncation-Effekt: Linienverzerrungen im NMR-Spektrum, die z.B. durch nicht abgeklungene NMR-Signale entstehen können.
- F: NMR-Signal am Eingang des digitalen Filters
- F': NMR-Signal am Ausgang des digitalen Filters
- [F]': Anteil des NMR-Signals F' am Ausgang des digitalen Filters, der direkt in Bezug zum NMR-Signal F am Eingang des digitalen Filters steht.
- F": NMR-Signal nach erfolgtem Rechenvorgang RV und ohne explizite Kompensation des Phasenganges.
- F"': NMR-Signal nach erfolgtem Rechenvorgang RV und inkl. einer expliziten Kompensation des Phasenganges.
- T_{erf}: Erfassungszeit des gesamten NMR-Signals nach der digitalen Filterung
- T_{A}: Länge des NMR-Signals F (= Aquisitionszeit)
- T_{B}: Gruppenlaufzeit des digitalen Filters. Die Ein- und Ausschwingvorgänge B₁ und B₂ im gefilterten NMR-Signal besitzen beide diese Länge T_{B}.
- B₁: Bereich vor der Funktion [F]', der einen Einschwingvorgang enthält.
- B₂: Bereich nach der Funktion [F]', der einen Ausschwingvorgang enthält
- [B₁]: Anfangsbereich innerhalb des Signals [F]', der einen Einschwingvorgang enthält
- [B₂]: Endbereich innerhalb des Signals [F]', der einen Ausschwingvorgang enthält
- N: Anzahl der Kopien von F', die vor und nach dem Signal F' positioniert werden müssen, um daraus das Signal F" gemäss dem erfindungsgemässen Verfahren zu berechnen.

### 6. Bezugszeichenliste

- 1a, 1b: Analoge Tiefpass Filter, sogenannte Anti-Aliasing-Filter, die für die Einhaltung des Nyquist-Kriteriums verantwortlich sind.
- 2a, 2b: Digitizer, mit denen die beiden analogen NMR-Signale, die in Quadratur zu einander stehen, digitalisiert werden.
- 3a, 3b: Digitale Filter, um den Frequenzbereich des NMR-Signals einzuschränken und danach eine Dezimation einleiten zu können.
- 4: Rechner, der den Rechenvorgang RV und die Fourier-Transformation ausführt.

## Patentansprüche

1. Verfahren zum Betrieb eines Kernspinresonanz(=NMR)- oder eines bildgebenden Magnetresonanz(=MRI)-Spektrometers mit einem im Niederfrequenzbereich eines Empfangssystems eingebauten digitalen Filter, in dessen Eingang ein NMR-Signal der zeitlichen Länge T_{A} eingespeist wird, und dessen Ausgangssignal aus einem Einschwingvorgang B₁ der zeitlichen Länge T_{B}, einem Signalanteil [F]' bestehend aus einem gefilterten FID- oder Echo-Signal der zeitlichen Länge T_{A} sowie einem Ausschwingvorgang B₂ der zeitlichen Länge T_{B} besteht, wobei dieses Ausgangssignal zuerst mit Hilfe eines Rechenvorganges RV modifiziert und anschließend durch eine Fourier-Transformation zu einem gewünschten NMR-Spektrum transformiert wird,
**dadurch gekennzeichnet,**
**dass** beim Rechenvorgang RV zuerst nur der Signalanteil [F]' erfasst wird, dass anschließend mindestens N Kopien des Einschwingvorganges B₁ in positiven zeitlichen Abständen T_{A} zueinander erzeugt und auf dem Signalanteil [F]' zeitlich so positioniert werden, dass das Ende des ersten Einschwingvorganges auf das Ende des Signalanteils [F]' zu liegen kommt, dass zudem mindestens N Kopien des Ausschwingvorganges B₂ in negativen zeitlichen Abständen T_{A} zueinander erzeugt und auf dem Signalanteil [F]' zeitlich so positioniert werden, dass der Anfang des ersten Ausschwingvorganges auf den Anfang des Signalanteils [F]' zu liegen kommt, und dass am Ende alle so definierten N Kopien des Einschwingvorganges B₁ und N Kopien des Ausschwingvorganges B₂ zum Signalanteil [F]' addiert werden, und davon nur der Bereich T_{A}, der den Signalanteil [F]' enthält, als resultierendes Signal F" des Rechenvorganges RV gewählt wird, wobei die Zahl N mit Hilfe der Formel N = T_{B} / T_{A} zu berechnen und auf die nächst höhere ganze Zahl aufzurunden ist.

2. Verfahren nach Anspruch 1, **dadurch gekennzeichnet, dass** der DC-Anteil im resultierenden Signal F" durch eine Subtraktion eines konstanten Wertes S_{DC} kompensiert wird und zum gewünschten DC-kompensierten Signal F" führt, wobei der Wert S_{DC} durch eine Mittelwert-Bildung des Endbereichs des resultierenden Signals F" bestimmt wird.

3. Verfahren nach Anspruch 2, **dadurch gekennzeichnet, dass** das DCkompensierte Signal F" mit einer Fensterfunktion W2(t) multipliziert wird, bevor sie anschließend der Fourier-Transformation zugeführt wird.

4. Verfahren nach Anspruch 2, **dadurch gekennzeichnet, dass** am Ende des DC-kompensierten Signals F" ein Bereich aus lauter Nullwerten angehängt wird, und das so entstandene Signal anschließend der Fourier-Transformation zugeführt wird.

5. Kernspinresonanz(=NMR)-Spektrometer oder bildgebendes Magnetresonanz(=MRI)-Spektrometer mit einem im Niederfrequenzbereich eines Empfangssystems eingebauten digitalen Filter, der nach dem Verfahren gemäß einem der vorhergehenden Ansprüche arbeitet.

## Claims

1. Method for operating a nuclear magnetic resonance (NMR) or a magnetic resonance imaging (MRI) spectrometer with a digital filter which is installed in the low-frequency region of a receiver system, whose input is fed with an NMR signal of time length T_{A} and whose output signal consists of a rising oscillation B₁ of time length T_{B}, a signal portion [F]', which consists of a filtered FID or echo signal of time length T_{A}, and a decaying oscillation B₂ of time length T_{B}, wherein this output signal is initially modified using a calculation process RV and subsequently transformed into a desired NMR spectrum through Fourier transformation,
**characterized in that**,
during the calculation process RV, initially only the signal portion [F]' is detected, that subsequently at least N copies of the rising oscillation B₁ are generated in positive time separations T_{A} relative to each other and are positioned on the signal portion [F]' in time such that the end of the first rising oscillation is positioned at the end of the signal portion [F]', that at least N copies of the decaying oscillation B₂ are generated in negative time shifts T_{A} relative to each other and are positioned on the signal portion [F]' in time such that the start of the first decaying oscillation is positioned at the start of the signal portion [F]' and that, finally, all N copies of the rising oscillation B₁ defined in this manner and N copies of the decaying oscillation B₂ defined in this manner are added to the signal portion [F]' and only portion T_{A} thereof, which contains the signal portion [F]' is selected as resulting signal F" of the calculation process RV, wherein the number N is to be calculated using the formula N=T_{B}/T_{A} and rounded to the next higher integer number.

2. Method according to claim 1, **characterized in that** the DC component in the resulting signal F" is compensated for through subtraction of a constant value S_{DC} and leads to the desired DC-compensated signal F", wherein the value S_{DC} is determined through forming an average value of the end region of the resulting signal F".

3. Method according to claim 2, **characterized in that** the DC-compensated signal F" is multiplied with a window function W2(t) before being subsequently Fourier transformed.

4. Method according to claim 2, **characterized in that** at the end of the DC-compensated signal F" zero values only are added and the signal produced thereby is subsequently Fourier transformed.

5. Nuclear magnetic resonance (NMR) spectrometer or magnetic resonance imaging (MRI) spectrometer with a digital filter which is installed in the low frequency region of a receiver system, which operates according to the method in accordance with any one of the preceding claims.

## Revendications

1. Procédé de fonctionnement d'un spectromètre de résonance magnétique nucléaire (= RMN) ou d'un spectromètre d'imagerie par résonance magnétique (IRM) avec un filtre numérique intégré dans la partie basse fréquence d'un système de réception, à l'entrée duquel est injecté un signal RMN de longueur temporelle T_{A} et dont le signal de sortie est composé d'un transitoire d'attaque B₁ de longueur temporelle T_{B}, d'une composante de signal [F]' composée d'un signal FID ou d'écho filtré de longueur temporelle T_{A} ainsi que d'un transitoire d'évanouissement B₂ de longueur temporelle T_{B}, ce signal de sortie étant d'abord modifié à l'aide d'une opération arithmétique RV et ensuite transformé en un spectre RMN souhaité par une transformation de Fourier,
**caractérisé en ce**
**que** lors de l'opération arithmétique RV, seule la composante de signal [F]' est d'abord détectée, qu'ensuite au moins N copies du transitoire d'attaque B₁ sont générées à intervalles temporels positifs T_{A} les unes des autres et positionnées dans le temps sur la composante de signal [F]' de manière que la fin du premier transitoire d'attaque se situe sur la fin de la composante de signal [F]', qu'au moins N copies du transitoire d'évanouissement B₂ sont générées à intervalles temporels négatifs T_{A} les unes des autres et positionnées dans le temps sur la composante de signal [F]' de manière que le début du premier transitoire d'évanouissement se situe sur le début de la composante de signal [F]', et qu'à la fin toutes les N copies du transitoire d'attaque B₁ et N copies du transitoire d'évanouissement B₂ ainsi définies sont additionnées à la composante de signal [F]', et parmi cela seule la plage T_{A} qui contient la composante de signal [F]' est choisie comme signal résultant F" de l'opération arithmétique RV, le nombre N étant calculé à l'aide de la formule N = T_{B} / T_{A} et arrondi au nombre entier immédiatement supérieur.

2. Procédé selon la revendication 1, **caractérisé en ce que** la composante DC dans le signal résultant F" est compensée par une soustraction d'une valeur constante S_{DC} et conduit au signal F" compensé DC souhaité, la valeur S_{DC} étant déterminée par une formation de moyenne de la plage terminale du signal résultant F".

3. Procédé selon la revendication 2, **caractérisé en ce que** le signal F" compensé DC est multiplié par une fonction de fenêtre W2(t) avant d'être ensuite amené à la transformation de Fourier.

4. Procédé selon la revendication 2, **caractérisé en ce qu'**à la fin du signal F" compensé DC est attachée une plage de valeurs nulles, et le signal ainsi produit est ensuite amené à la transformation de Fourier.

5. Spectromètre de résonance magnétique nucléaire (= RMN) ou spectromètre d'imagerie par résonance magnétique (IRM) avec un filtre numérique intégré dans la partie basse fréquence d'un système de réception qui fonctionne selon une des revendications précédentes.
